# EUROPÄISCHE PATENTSCHRIFT

(11) **EP 0 985 224 B1**
(45) Veröffentlichungstag und Bekanntmachung des Hinweises auf die Patenterteilung: **07.03.2007**
(21) Anmeldenummer: 98932084.1
(22) Anmeldetag: 26.05.1998
(51) Int. Cl.: H01L 21/00

(54) **VORRICHTUNG UND VERFAHREN ZUM GETRENNTEN TRANSPORTIEREN VON SUBSTRATEN**
DEVICE AND METHOD FOR SEPARATELY TRANSPORTING SUBSTRATES
DISPOSITIF ET PROCEDE POUR TRANSPORTER SEPAREMENT DES SUBSTRATS

(30) Priorität: 28.05.1997 DE 19722408
(43) Veröffentlichungstag der Anmeldung: 15.03.2000
(73) Patentinhaber: Singulus Technologies AG, 63796 Kahl/Main (DE)
(72) Erfinder: KEMPF, Stefan, D-63755 Alzenau (DE)
(74) Vertreter: Vossius & Partner
(86) Internationale Anmeldenummer: PCT/EP1998/003094
(87) Internationale Veröffentlichungsnummer: WO 1998/054754

(56) Entgegenhaltungen:
- DE-C- 19 606 763
- US-A- 3 675 563
- US-A- 5 612 068

## Beschreibung

Die Erfindung betrifft eine Vorrichtung und ein Verfahren zur Herstellung eines Substratverbundes und kann insbesondere bei der Herstellung von DVD's (Digital Versatile Discs) verwendet werden.

Insbesondere bei der Herstellung von DVD's ist es von entscheidender Bedeutung, zwei Substrate, die durch Bonden zu einer DVD gefügt werden, beim Transport auseinanderzuhalten und nicht zu vertauschen.

Bei bekannten Transportsystemen für den DVD-Prozeß (Cube der Firma Balzers, siehe DE-C2-42 35 677) erfolgt die Zufuhr der Substrate für die DVD durch eine einzige Schleuse. Dabei besteht die Gefahr der Verwechslung der unterschiedlichen Substrate.

Aus der US-A-4 969 790 ist eine Vorrichtung und ein Verfahren zum Beschichten von Substraten in einer Vakuumkammer bekannt, wobei ein drehbarer Substrathalter mehrere Substratempfänger trägt, um Substrate auf einem kreisförmigen Weg von je einer Schleuse zu einer mit dieser verbundenen Beschichtungsstation und wieder zu derselben Schleuse zurück zu transportieren.

Weiterhin ist aus dem Prospekt: Speedline, DVD-Speedline plus, Leybold Systems GmbH, 2/97 ein Transportsystem bekannt, wobei unterschiedliche Substrate durch eine Drehbewegung zu unterschiedlichen Bearbeitungsstationen transportiert werden.

Die DE 196 06 764 C1 offenbart eine Vorrichtung zum Greifen, Halten und/oder Transportieren von Substraten. Von einer Eingangsstation wird ein Substrat an mehrere in Reihe oder kreisförmig angeordnete Prozeßstationen mittels Greiferelementen geführt. Mehrere Greiferarme sind in horizontaler und/oder vertikaler Richtung verstellbar. Dabei sind einige Greiferelemente gemeinsam in horizontaler und/oder vertikaler Richtung verstellbar, und zumindestens ein Greiferarm ist unabhängig von den übrigen Greiferarmen in mindestens eine der Bewegungsrichtungen verstellbar.

Der Erfindung liegt die Aufgabe zugrunde, eine Vorrichtung und ein Verfahren zum getrennten Transportieren von Substraten während der Herstellung eines Substratverbundes zur Verfügung zu stellen, wobei ein Vertauschen der Substrate zuverlässig verhindert wird.

Die Aufgabe wird mit den Merkmalen der Patentansprüche 1 und 10 gelöst.

Bei der Lösung geht die Erfindung von folgenden Grundgedanken aus.

Zwei Zuführstationen sind auf einem Kreisbogen in einem vorgegebenen Winkelabstand α angeordet. Weiterhin sind auf dem Kreisbogen zwei Beschichtungsstationen angeordnet, die untereinander mit dem vorgegebenen Winkel α beabstandet sind. Vier Greifer sind auf demselben Kreisbogen angeordnet und gleichzeitig um eine Achse durch den Kreismittelpunkt um einen Winkel β drehbar. Zwischen dem ersten und zweiten Greifer, sowie zwischen dem dritten und vierten Greifer, liegt der Winkelabstand α vor, und zwischen dem ersten und dritten Greifer, sowie dem zweiten und vierten Greifer liegt der Winkelabstand β vor. Zwei Greifer übernehmen gleichzeitig je ein Substrat und transportieren die Substrate z.B. durch eine 120°-Drehung der Greiferanordnung zu den Beschichtungsstationen. Danach transportieren die Greifer die unterschiedlichen Substrate zu zwei Abgabestationen. Durch Übernahme neuer Substrate durch die Greifer ist der Transportvorgang wiederholbar.Die Greifer machen eine Pendelbewegung. Zwei Greifer transportieren die Substrate von den Zuführstationen zu den Beschichtungsstationen und zwei Greifer von den Prozeßstationen zu den Abgabestationen in einer hin- und hergehenden Bewegung.

Die Vorteile der Erfindung liegen in der Vermeidung von Vertauschungen der Substrate.

Im folgenden wird die Erfindung anhand der Zeichnungen näher erläutert. Es zeigen:
- Fig. 1: ein Prinzipbild der erfindungsgemäßen Vorrichtung,
- Fig. 2: eine Draufsicht auf eine erfindungsgemäße Ausführungsform in Verbindung mit einer Anlage zur Herstellung von DVDs.

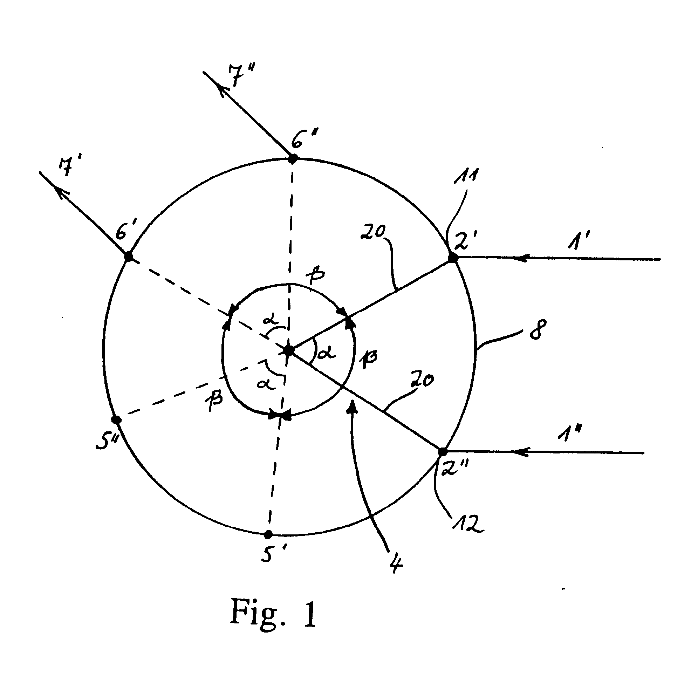

Fig. 1 zeigt den prinzipiellen Aufbau der erfindungsgemäßen Vorrichtung in der Draufsicht. Zwei getrennte Transportstrecken 1', 7' und 1", 7" sind über eine Transporteinrichtung 4 miteinander verbunden. Die Vorrichtung weist zwei Zufuhrstationen 2', 2",zwei Beschichtungsstationen 5', 5" und zwei Abgabestationen 6', 6" auf. Die Transporteinrichtung 4 weist um eine Drehachse 3 drehbare Greifer 11, 12 auf, die mittels Armen 20 auf einem Kreisbogen 8 in einem vorgegebenen Winkelabstand α angeordnet sind. Zwischen den beiden Zuführstationen 2', 2", den zwei Prozeßstationen 5', 5" und den zwei Abgabestationen 6', 6" besteht der gleiche vorgegebene Winkelabstand α. Die an den Zuführstationen 2' bzw. 2" von den Greifern 11 und 12 übernommenen Substrate 1' bzw. 1" werden durch eine Drehbewegung um einen Winkel β zu den Prozeßstationen 5' bzw. 5" und/oder den Abgabestationen 6' bzw. 6" transportiert. Der Drehwinkel β richtet sich nach dem Abstand der unterschiedlichen Stationen. Er ist jedoch vorzugsweise größer als der Winkel α zwischen zwei gleichen Stationen. Auf diese Weise können auch mehr als die in Fig. 1 dargestellten drei Stationspaare auf einem Kreisbogen angeordnet werden.

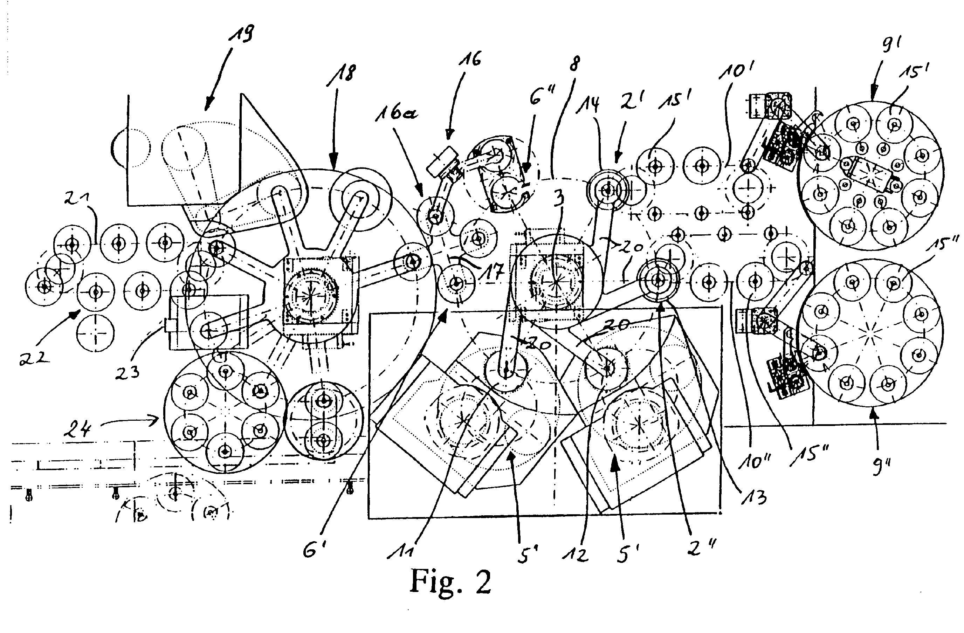

Fig. 2 zeigt eine erfindungsgemäße Ausführungsform in Verbindung mit einer Anlage zur Herstellung von DVD. Dabei werden Substrate 15' und 15" von Magazinen oder Spindeln 9' bzw. 9" über Transportwege 10' bzw. 10" zu den Zuführstationen 2' bzw. 2" transportiert. Die Zuführstationen sind auf einem Kreisbogen 8 in einem Abstand von vorzugsweise 60° angeordnet. Weiterhin befinden sich auf demselben Kreis zwei Beschichtungsstationen 5', 5" und zwei Abgabestationen 6' und 6", die untereinander und gegenüber den Zufuhrstationen einen Abstand von 60° aufweisen. Eine um die Achse 3 des Kreisbogens 8 drehbare Transporteinrichtung 4 weist Greifer 11, 12, 13 und 14 zum Transportieren der Substrate 15' und 15" auf dem Kreis 8 auf. In Figur 2 übernehmen die Greifer 11 und 12 die Substrate 15" bzw. 15' in den Beschichtungsstationen 5" bzw. 5' und die Greifer 14 und 13 übernehmen die Substrate 15' bzw. 15" in den Zuführstationen 2' bzw. 2". Dadurch wird sichergestellt, daß Substrate 15' aus dem Transportweg 10' nur zu der Beschichtungsstation 5' und Substrate 15" vom Transportweg 10" nur zur Beschichtungsstation 5" transportiert werden können. Von den Beschichtungsstationen 5" bzw. 5' bringen die Greifer 11 bzw. 12 die Substrate dann zu Abgabestationen 6" bzw. 6'. Die frei gewordenen Greifer 11 und 12 werden dann wieder zu den Beschichtungsstationen 5" bzw. 5' zurückgedreht und gleichzeitig werden die Greifer 13 und 14 zu den Zuführstationen 2" bzw. 2' zurückgedreht. Die Greifer führen dabei eine hin- und hergehende Bewegung (Pendeln) aus. Auf diese Weise können an die jeweiligen Stationen optimal angepaßte Greifer verwendet werden. Es besteht aber auch die Möglichkeit, die Stationen zu standardisieren und einen einheitlichen Greifertyp zu verwenden.

In der Anlage gemäß Fig. 2 sind die Beschichtungsstationen 5' und 5" z.B. Kathodenzerstäubungsanlagen, in denen die Substrate 15' und 15" beschichtet werden. Die Greifer 13 bzw. 14 fahren die Substrate 15" bzw. 15' in die Schleusen (nicht dargestellt) der entsprechenden Kathodenzerstäubungsanlagen, wo die Substrate 15' mit einer voll reflektierenden Schicht aus z. B. Aluminium und die Substrate 15" mit einer halbdurchlässigen Schicht, z.B. Gold beschichtet werden. Nach einem zyklischen Umlauf durch die Kathodenzerstäubungsanlage werden die Substrate 15" und 15' durch die entsprechenden Greifer 11 und 12 wieder aufgenommen und zu den Abgabestationen 6" und 6' transportiert. Der Abgabestation 6" ist eine Wendevorrichtung 16 und der Abgabestation 6' ist ein Drehteller 17 nachgeschaltet. Der Drehteller 17 transportiert das Substrat 15' in den Bereich 16a der Wendevorrichtung 16, die das gewendete Substrat 15'' auf dem Substrat 15' plaziert. Danach werden die beiden Substrate gebondet. Über eine weitere Transporteinrichtung 18 werden die gebondeten Substrate 15 (zusammengesetzt aus den Substraten 15', 15") in eine Trockeneinrichtung 19 zum Härten der Bondschicht (z.B. durch UV-Bestrahlung), danach über eine Transporteinrichtung 21 zu einer Wendestation 22 und einer Prüfeinrichtung (Scaneinrichtung) 23 und schließlich zur Ausgabestation 24 transportiert.

In der Wendestation 22 wird das gebondete Substrat 15 gewendet, so daß die Hälfte 15" unten liegt. Danach erfolgt der Transport zur Prüfeinrichtung 23. Die Wendestation 22 ist vorgesehen, um in Abhängigkeit vom Typ der DVD ein Scannen durch das Substrat 15" und die transparente halbdurchlässige Schicht, z.B. Goldschicht von unten zu ermöglichen, wenn die DVD, wie im Beispiel von Fig. 2 dargestellt, oben ein Substrat 15" mit einer Goldschicht aufweist, um in der Trockeneinrichtung 19 von oben durch die semitransparente Goldschicht hindurch mit geringerem Energie- und daher Zeitaufwand, das Trocknen der Bondschicht auszuführen. Die Wendestation 22 wird nicht zugeschaltet, wenn das obere Substrat 15", wie es bei anderen DVDs (Typ DVD5) der Fall ist, nicht beschichtet ist, und das untere Substrat 15' mit Aluminium beschichtet ist. In diesem Fall befindet sich die DVD bereits in der für das Scannen in der Prüfstation erforderlichen Lage. Die wahlweise zuschaltbare Wendestation 22 erhöht somit die Flexibilität und Verwendbarkeit einer Anlage zur Herstellung unterschiedlicher DVDs, z.B. DVD9 oder DVD5.

Daher ist die Verwendung einer wahlweise zuschaltbaren Wendestation allgemein bei der DVD-Herstellung auch für sich allein von Vorteil.

Anstelle mit den Magazinen (Spindeln) 9' bzw. 9" können die Transportstrecken 10' bzw. 10" direkt mit einer Spritzgießmaschine zur Herstellung der Substrate 15' bzw. 15" verbunden sein.

Die erfindungsgemäße Vorrichtung ermöglicht den einfachen, vertauschungsfreien Transport von Substraten auf zwei getrennten Transportstrecken, wobei zur Nachrüstung der Anlage die Bearbeitungsstationen 5' und 5" gegebenenfalls nachträglich in einfacher Weise eingebaut werden können.

Es besteht auch die Möglichkeit, nach dem Baukastenprinzip die Transporteinrichtung 4 zusammen mit der Bondeinrichtung 16a, der Transporteinrichtung 18, der Trockenstation 19, der Wendestation 22 und der Prüfeinrichtung 23 mit beliebigen anderen vorgeschalteten Einrichtungen (z.B. Sputteranlage, Spritzgießanlage) und Prozeßstationen zu kombinieren.

## Patentansprüche

1. Vorrichtung zur Herstellung eines Substratverbundes bestehend aus zwei miteinander gebondeten Substraten, mit
a) einer auf dem Kreisbogen (8) in einem Winkelabstand α angeordneten ersten und zweiten Zuführstation (2" bzw. 2') zum Zuführen von je einem ersten und einem zweiten Substrat (15', 15") für eine erste und zweite Substratverbund-Hälfte,
b) einer ersten und einer zweiten auf dem Kreisbogen (8) in dem Winkelabstand α angeordnete Beschichtungsstation (5", 5'),
c) einer auf dem Kreisbogen (8) in dem Winkelabstand α angeordneten ersten und zweiten Abgabestation (6" bzw. 6') für das erste bzw. zweite beschichtete Substrat, wobei der ersten Abgabestation (6") eine Vorrichtung zum Wenden des ersten Substrats und Plazieren auf dem zweiten Substrat nach geschaltet ist,
und wobei zwischen dem ersten Zufuhrstation, dem ersten Beschichtungsstation und dem ersten Abgabestation jeweils ein Wickel β vorliegt, und zwischen dem zweiten Zufuhrstation, dem zweiten Beschichtungsstation und dem zweiten Abgabestation jeweils der Winkel β vorliegt.
d) einer ersten Transporteinrichtung (4) zum Transportieren der ersten und zweiten Substrate auf dem Kreisbogen (8) mit lediglich vier auf dem Kreisbogen um einen Winkel β drehbaren Greifern (11, 12, 13, 14), wobei zwischen dem ersten und zweiten Greifer (11 bzw. 12) sowie zwischen dem dritten und vierten Greifer (13 bzw. 14) jeweils der vorgegebene Winkelabstand α und zwischen dem ersten und dritten Greifer (11 bzw. 13) sowie zwischen dem zweiten und vierten Greifer (12 bzw. 14) der Winkel β vorliegt, so daß je ein Greifer jeweils das erste bzw. zweite Substrat von den Zuführstationen (2" bzw. 2') zu den Beschichtungsstationen (5" bzw. 5') und von den Beschichtungsstationen (5" bzw. 5') zu den Abgabestationen (6" bzw. 6') transportieren kann.
e) einer Bondstation zum Bonden der ersten und zweiten Substrate zu einem Substratverbund,
f) einer Trockeneinrichtung zum Härten der Bondschicht,
g) einer Vorrichtung zum Wenden des Substratverbundes,
h) einer Prüfstation zum Prüfen des Substratverbundes,
i) einer Ausgabestation für den Substratverbund und
j) einer zweiten Transporteinrichtung zum Transportieren des Substratverbundes zwischen den Stationen gemäß den Merkmalen e) bis i).

2. Vorrichtung nach Anspruch 1, wobei der erste und zweite Greifer (11, 12) sowie der dritte und vierte Greifer (13, 14) zu den Beschichtungsstationen (5", 5') bzw. den Zuführstationen (2", 2') zurückgedreht werden können.

3. Vorrichtung nach Anspruch 1 oder 2, wobei die Beschichtungsstationen (5" bzw. 5') Kathodenzerstäubungsanlagen sind.

4. Vorrichtung nach Anspruch 1, 2 oder 3, wobei der zweiten Abgabestation (6') ein Drehteller nach geschaltet ist, der das zweite Substrat in den Bereich der Wendevorrichtung der ersten Abgabestation (6") transportieren kann.

5. Vorrichtung nach einem der Ansprüche 1 bis 4, wobei zwischen der Trockeneinrichtung und der Wendeeinrichtung für den Substratverbund eine dritte Transporteinrichtung (21) zum Transport des Substratverbundes vorgesehen ist.

6. Vorrichtung nach einem der Ansprüche 1 bis 5, wobei die erste und die zweite Zuführstation (2" bzw. 2') mit Magazinen oder Spindeln (9', 9'') für die Substrate oder mit einer Spritzgussanlage für die Substrate über eine Transportstrecke verbunden sind.

7. Vorrichtung nach einem der Ansprüche 1 bis 6, wobei der Winkel β größer als der Winkelabstand α ist.

8. Vorrichtung nach Anspruch 7, wobei der Winkelabstand α gleich 60° ist.

9. Vorrichtung nach Anspruch 7, wobei der Winkel β jeweils 120° beträgt.

10. Verfahren mittels der Vorrichtung nach einem der Ansprüche 1 bis 9 zum Herstellen eines Substratverbundes, mit den Schritten:
a) Transportieren eines ersten und eines zweiten Substrats (15' und 15") auf Transportwegen (10' bzw. 10") zu Zuführstationen (2' bzw. 2"),
b) Transportieren der ersten und zweiten Substrate (15' bzw. 15") durch den vierten und dritten Greifer (14 bzw. 13) zu Beschichtungsstationen (5' bzw. 5") durch Drehen der Transporteinrichtung um 120°,
c) Beschichten des ersten Substrats (15') in der ersten Beschichtungsstation (5') und des zweiten Substrats (15") in der zweiten Beschichtungsstation (5"),
d) Transportieren der beiden beschichteten Substrate (15' bzw. 15") durch den zweiten und ersten Greifer (12 bzw. 11) zu einer ersten Abgabestation (6'), die auf einem Drehteller (17) liegt, bzw. zu einer zweiten Abgabestation (6"), der eine Wendevorrichtung (16) nachgeschaltet ist,
e) Wenden des zweiten Substrats (15") in der Wendevorrichtung (16) und Plazieren dieses zweiten Substrats auf dem ersten Substrat (15'),
f) Bonden der Substrate (15' und 15") in einer Bondeinrichtung (16a) zu dem Substratverbund,
g) Transportieren des Substratverbundes mittels einer Transporteinrichtung (18) in eine Trockenstation (19),
h) Trocknen des Substratverbundes (15', 15") zum Härten der Bondschicht,
i) Transportieren des Substratverbundes (15', 15") zu einer Prüfstation (23) und zur Ausgabestation (24), und
j) Zurückdrehen der ersten und zweiten Greifer (11, 12) sowie der dritten und vierten Greifer (13, 14) zu den Beschichtungsstationen (5", 5') bzw. den Zuführstationen (2", 2').

11. Verfahren nach Anspruch 10, wobei zwischen den Schritten h) und i) der Substratverbund (15' und 15") in einer Wendestation (22) gewendet wird, so dass das zweite Substrat (15") unten liegt und in der Prüfstation (23) durch es von unten gescannt werden kann.

12. Verfahren nach Anspruch 10 oder 11, wobei die Beschichtungsstationen (5', 5") Kathodenzerstäubungsanlagen sind.

13. Vorrichtung und Verfahren nach einem der Ansprüche 1 bis 12, wobei der Substratverbund eine DVD ist und das erste und zweite Substrat (15', 15") Hälften einer DVD sind.

## Claims

1. A device for producing a substrate composite consisting of two substrates bonded together, said device comprising
(a) a first and a second input station (2", 2', respectively) being arranged on the circular arc (8) at an angular distance α and respectively supplying a first and a second substrate (15', 15") for a first and a second substrate composite half,
(b) a first and a second coating station (5", 5') arranged on the circular arc (8) at the angular distance α,
(c) a first and a second output station (6", 6', respectively) arranged on the circular arc (8) at the angular distance α for the first and the second bonded substrates, respectively, wherein a device for turning the first substrate and placing it onto the second substrate is arranged downstream of the first output station (6"),
and wherein there is an angle β each between the first input station, the first coating station and the first output station and there is the angle β each between the second input station, the second coating station and the second output station,
(d) a first transporting means (4) for transporting the first and second substrates on the circular arc (8) and comprising at least four grippers (11, 12, 13, 14) which can be rotated on the circular arc through an angle β, wherein there is the predetermined angular distance α between the first and second grippers (11, 12, respectively) as well as between the third and fourth grippers (13, 14, respectively) and the angle β between the first and third grippers (11, 13, respectively) as well as between the second and fourth grippers (12, 14, respectively), so that a respective one of the grippers can transport a respective one of the first and second substrates from the respective input stations (2", 2') to the respective coating stations (5", 5') and from the respective coating stations (5", 5') to the respective output stations (6", 6'),
(e) a bonding station for bonding the first and second substrates to form a substrate composite,
(f) a drying means for curing the bond layer,
(g) a means for turning the substrate composite,
(h) a test station for testing the substrate composite,
(i) an output station for the substrate composite, and
(j) a second transporting means for transporting the substrate composite between the stations according to features (e) to (i).

2. The device according to claim 1, wherein the first and second grippers (11, 12) as well as the third and fourth grippers (13, 14) can respectively be turned back to the coating stations (5", 5') and the supply stations (2", 2').

3. The device according to claim 1 or 2, wherein the coating stations (5", 5') are cathode sputtering units.

4. The device according to claim 1, 2 or 3, wherein a rotary table which can transport the second substrate into the area of the turning device of the first output station (6") is arranged downstream of the second output station (6').

5. The device according to any one of claims 1 to 4, wherein a third transporting means (21) for transporting the substrate composite is provided between the drying means and the turning means for the substrate composite.

6. The device according to any one of claims 1 to 5, wherein the first and the second input stations (2", 2', respectively) are connected with magazines or spindles (9', 9") for the substrates or with an injection molding unit for the substrates via a transport path.

7. The device according to any one of claims 1 to 6, wherein the angle β is larger than the angular distance α.

8. The device according to claim 7, wherein the angular distance α is 60°.

9. The device according to claim 7, wherein the angle β is in each case 120°.

10. A method for producing a substrate composite by means of the device according to any one of claims 1 to 9, said method comprising the steps of:
(a) transporting a first and a second substrate (15' and 15") on respective transport paths (10', 10") to respective input stations (2', 2"),
(b) transporting the first and second substrates (15', 15", respectively) by means of the fourth and third grippers (14, 13, respectively) to respective coating stations (5', 5") by rotating the transport device by 120°,
(c) coating the first substrate (15') in the first coating station (5') and the second substrate (15") in the second coating station (5"),
(d) transporting the two coated substrates (15', 15") by means of the second and first grippers (12, 11, respectively) to a first output station (6') located on a rotary table (17) and to a second output station (6") downstream of which a turning device (16) is arranged, respectively,
(e) turning the second substrate (15") in the turning device (16) and placing said second substrate onto the first substrate (15'),
(f) bonding the substrates (15' and 15") in a bonding means (16a) to form said substrate composite,
(g) transporting the substrate composite by means of a transporting means (18) into a drying station (19),
(h) drying the substrate composite (15', 15") in order to cure the bond layer,
(i) transporting the substrate composite (15', 15") to a test station (23) and to the output station (24), and
(j) turning the first and second grippers (11, 12) as well as the third and fourth grippers (13, 14) back to the coating stations (5", 5') and the supply stations (2", 2'), respectively.

11. The method according to claim 10, wherein between steps (h) and (i) the substrate composite (15' and 15") is turned in a turning station (22) so that the second substrate (15") lies on the bottom and it is thus possible to scan through it from the bottom in the test station (23).

12. The method according to claim 10 or 11, wherein the coating stations (5', 5") are cathode sputtering units.

13. The device and the method according to any one of claims 1 to 12, wherein the substrate composite is a DVD and the first and second substrates (15', 15") are the halves of a DVD.

## Revendications

1. Dispositif de fabrication d'un substrat composite constitué de deux substrats collés l'un à l'autre, comprenant
a) un premier et un second postes d'alimentation (2'' respectivement 2') disposés sur l'arc de cercle (8) selon une distance angulaire α, destinés à amener un premier et un second substrat (15', 15'') pour une première et une seconde moitiés de substrat composite,
b) un premier et un second postes de recouvrement (5'', 5') disposés sur l'arc de cercle (8) selon la distance angulaire α,
c) un premier et un second postes de distribution (6'' respectivement 6') disposés sur l'arc de cercle (8) selon la distance angulaire α pour le premier et/ou le second substrats revêtus, un dispositif de rotation du premier substrat et de placement sur le second substrat étant monté derrière le premier poste de distribution (6"), et respectivement un angle β étant présent entre le premier poste d'alimentation, le premier poste de recouvrement et le premier poste de distribution, et respectivement l'angle β étant présent entre le second poste d'alimentation, le second poste de recouvrement et le second poste de distribution,
d) un premier système de transport (4) destiné à transporter le premier et le second substrats sur l'arc de cercle (8) avec seulement quatre pinces (11, 12, 13, 14) pouvant être amenées en rotation sur l'arc de cercle autour d'un angle β, respectivement la distance angulaire α prédéfinie étant présente entre la première et la deuxième pinces (11 respectivement 12) ainsi qu'entre la troisième et la quatrième pinces (13 respectivement 14) et l'angle β étant présent entre la deuxième et la troisième pinces (11 respectivement 13) ainsi qu'entre la deuxième et la quatrième pinces (12 respectivement 14), de sorte que respectivement une paire peut transporter le premier et/ou le second substrats des postes d'alimentation (2'' respectivement 2') aux postes de recouvrement (5'' respectivement 5') et des postes de recouvrement (5'' respectivement 5') aux postes de distribution (6'' respectivement 6'),
e) un poste d'assemblage destiné à assembler les premier et second substrats pour former un substrat composite,
f) un système de séchage destiné à durcir la couche assemblée,
g) un dispositif destiné à amener en rotation le substrat composite,
h) un poste de contrôle destiné à contrôler le substrat composite,
i) un poste d'évacuation du substrat composite et
j) un deuxième système de transport destiné à transporter le substrat composite entre les postes selon les caractéristiques e) à i).

2. Dispositif selon la revendication 1, la première et la deuxième pinces (11, 12) ainsi que la troisième et la quatrième pinces (13, 14) pouvant être ramenées par rotation aux postes de recouvrement (5'', 5') et/ou aux postes d'alimentation (2'', 2').

3. Dispositif selon la revendication 1 ou 2, les postes de recouvrement (5'' respectivement 5') étant des installations de pulvérisation cathodique.

4. Dispositif selon la revendication 1, 2 ou 3, un plateau tournant, qui peut transporter le second substrat dans la zone du dispositif de rotation du premier poste de distribution (6''), étant monté le second poste de distribution (6').

5. Dispositif selon l'une quelconque des revendications 1 à 4, un troisième système de transport (21), destiné à transporter le substrat composite, étant prévu entre le système de séchage et le système de rotation.

6. Dispositif selon l'une quelconque des revendications 1 à 5, le premier et le second postes d'alimentation (2'' respectivement 2') étant reliés à des chargeurs ou à des broches (9', 9'') pour les substrats ou à une installation de moulage par injection pour les substrats sur un trajet de transport.

7. Dispositif selon l'une quelconque des revendications 1 à 6, l'angle β étant supérieur à la distance angulaire α.

8. Dispositif selon la revendication 7, la distance angulaire α étant égale à 60°.

9. Dispositif selon la revendication 7, l'angle β mesurant respectivement 120°.

10. Procédé au moyen du dispositif selon l'une quelconque des revendications 1 à 9, destiné à fabriquer un substrat composite, comprenant les étapes :
a) de transport d'un premier et d'un second substrats (15' et 15'') sur des trajets de transport (10' respectivement 10'') en direction des postes d'alimentation (2' respectivement 2"),
b) de transport des premier et second substrats (15' respectivement 15'') à travers les quatrième et troisième pinces (14 respectivement 13) en direction des postes de recouvrement (5' respectivement 5'') par la rotation du système de transport sur 120°,
c) de recouvrement du premier substrat (15') dans le premier poste de recouvrement (5') et du second substrat (15'') dans le second poste de recouvrement (5''),
d) de transport des deux substrats recouverts (15' respectivement 15'') par la deuxième et la première pinces (12 respectivement 11) en direction d'un premier poste de distribution (6'), qui se situe sur un plateau tournant (17), respectivement en direction d'un second poste de distribution (6''), derrière lequel est monté un dispositif de rotation (16).
e) de rotation du second substrat (15'') dans le dispositif de rotation (16) et de placement de ce second substrat sur le premier substrat (15'),
f) d'assemblage des substrats (15' et 15'') dans un système d'assemblage (16a) pour former le substrat composite,
g) de transport du substrat composite au moyen d'un système de transport (18) dans un poste de séchage (19),
h) de séchage du substrat composite (15', 15'') pour durcir la couche assemblée,
i) de transport du substrat composite (15', 15") en direction d'un poste de contrôle (23) et du poste d'évacuation (24), et
j) de retour de la première et de la deuxième pinces (11, 12) ainsi que de la troisième et la quatrième pinces (13, 14) en direction des postes de recouvrement (5'', 5') et/ou des postes d'alimentation (2'', 2').

11. Procédé selon la revendication 10, le substrat composite (15' et 15'') étant amené en rotation dans un poste de rotation (22) entre les étapes h) et i), de sorte que le second substrat (15'') se situe dessous et dans le poste de contrôle (23) peut être scanné du dessous à travers celui-ci.

12. Procédé selon la revendication 10 ou 11, les postes de recouvrement (5', 5'') étant des installations de pulvérisation cathodique.

13. Dispositif et procédé selon l'une quelconque des revendications 1 à 12, le substrat composite étant un DVD et le premier et le second substrats (15', 15'') étant les moitiés d'un DVD.
